Europäisches Patentamt

European Patent Office

Office européen des brevets

(11) Publication number: **0 121 198 B1**

# EUROPEAN PATENT SPECIFICATION

(45) Date of publication of patent specification: **09.09.92** (51) Int. Cl.5: **H01L  29/08**, H01L  29/72

(21) Application number: **84103234.5**

(22) Date of filing: **23.03.84**

(54) **Semiconductor device having a variable impedance.**

(30) Priority: **31.03.83 JP 56095/83**

(43) Date of publication of application:
**10.10.84 Bulletin  84/41**

(45) Publication of the grant of the patent:
**09.09.92 Bulletin  92/37**

(84) Designated Contracting States:
**DE FR GB**

(56) References cited:

IBM TECHNICAL DISCLOSURE BULLETIN, vol. 14, no. 1, June 1971, page 302, New York, US; H. BERGER et al.: "Base ring transistor and method of production"

IBM TECHNICAL DISCLOSURE BULLETIN, vol. 26, no. 4, September 1983, pages 1992-1994, New York, US; H.S. BHATIA et al.: "Process to increase the inverse gain of an NPN transistor"

(73) Proprietor: **KABUSHIKI KAISHA TOSHIBA
72, Horikawa-cho Saiwai-ku
Kawasaki-shi Kanagawa-ken 210(JP)**

(72) Inventor: **Fukuda, Hirokazu
5-1103, Dream Heights 1403 Matano-cho
Totsuka-ku Yokohama-shi(JP)**
Inventor: **Hashimoto, Mararu
1425-12, Fukaya
Ayasa-shi Kanagawa-ken(JP)**

(74) Representative: **Lehn, Werner, Dipl.-Ing. et al
Hoffmann, Eitle & Partner Patentanwälte Arabellastrasse 4
W-8000 München 81(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to an automatic control circuit having a variable resistor element, and is applicable inter alia to a level control (ALC) circuit.

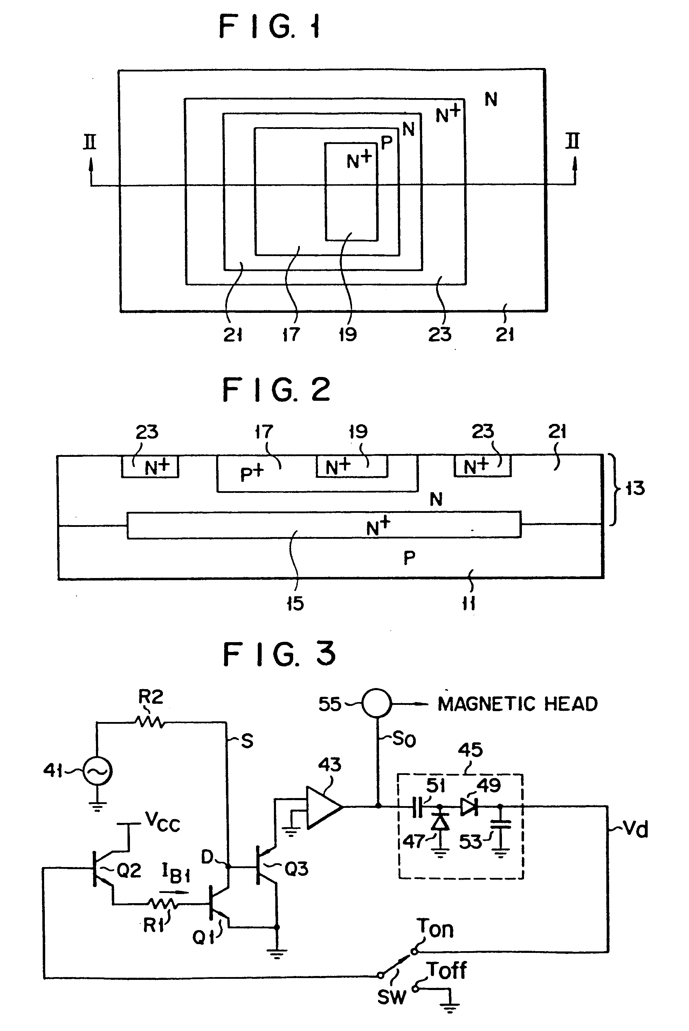

An ALC circuit is known in which an NPN type transistor structured as shown in Figs. 1 and 2 is used as a variable resistor element.

As shown, in the semiconductor device, an N type semiconductor layer 13 is layered over a P type semiconductor substrate 11, with a buried layer 15 positioned between the semiconductor substrate 11 and the semiconductor layer 13. Formed in the upper surface of the semiconductor layer 13 is a $P^+$ layer 17 serving as a base. Further formed in the upper surface of the $P^+$ layer 17 is an $N^+$ layer 19 serving as an emitter. The remaining portion of the semiconductor layer 13 serves as a collector 21. An N type, high concentration layer 23 is further formed in the upper surface of the collector 21. Actually, the collector 21, the base 17, and the emitter 19 are provided with electrodes, respectively. Further, an oxide film is formed over the semiconductor layer 13. However, those are omitted for simplicity of illustration. The layers are electrically isolated from other islands by $P^+$ separating layers (not shown).

The operation of the transistor thus structured, which is assembled as a variable resistor element, into an ALC circuit will be described referring to Figs. 3 - 5.

a) When the ALC circuit is in OFF state:

In this state of the Fig. 3 circuit, a switch SW is at a fixed contact Toff. Accordingly, the base of the second transistor Q2 is placed at ground level. Under this condition, the transistor Q2 is in OFF state. So no current flows into the second transistor Q2. And no base current is fed to the first transistor Q1 through a resistor R1. The first transistor Q1 is in OFF state with an infinite resistance between the collector and the emitter of the first transistor Q1. A third transistor Q3 is connected at the base and the collector respectively to the collector and the emitter of the first transistor Q1. If a DC component of the collector current of the third transistor Q3 is 30μA and the common emitter current transfer ratio $h_{FE}$ is 30, the DC component of the base current of the third transistor Q3 is 1μA (30μA/30). The base current of 1μA flows into a signal source 41 via a resistor R2 of about 1KΩ. If the impedance of the signal source 41 is 0Ω, the DC component of the base voltage of the third transistor Q3 is 1mV (1μA X 1KΩ). An AC signal S supplied from the signal source 41 is superposed on the DC component of the base voltage of the third transistor Q3. A DC component of the base voltage of the third transistor Q3 is approximately 1mV and is substantially equal to the ground level. Therefore, the AC signal S from the signal source 41 is directly applied to the base of the third transistor Q3, not through a coupling capacitor. As shown, the third transistor Q3 is used in an emitter follower manner. Further, as previously stated, the resistance between the collector and emitter of the first transistor Q1 is infinite. Under this condition, the AC signal S is transmitted to the emitter of the third transistor Q3 without being amplified and attenuated, and is input to an amplifier 43. The AC signal input to the amplifier 43 is amplified and is output as an output signal So. The circuit arrangement requires use of a PNP transistor at the input circuit of the amplifier 43. The output signal So is input to an ALC detector circuit 45. The ALC detector circuit 45 produces a DC voltage signal Vd which corresponds to an amplitude of the signal So. Further, the ALC detector circuit 45 may be comprised of diodes 47 and 49 and capacitors 51 and 53 which are combined as shown. At this time, the switch SW is at the contact Toff, as already mentioned. Therefore, the signal Vd output from the ALC detector circuit 45 never influences the ALC circuit per se in any way. The output signal So is output to, e.g., a magnetic head (not shown) via the output terminal 55.

b) When the ALC circuit is in ON state:

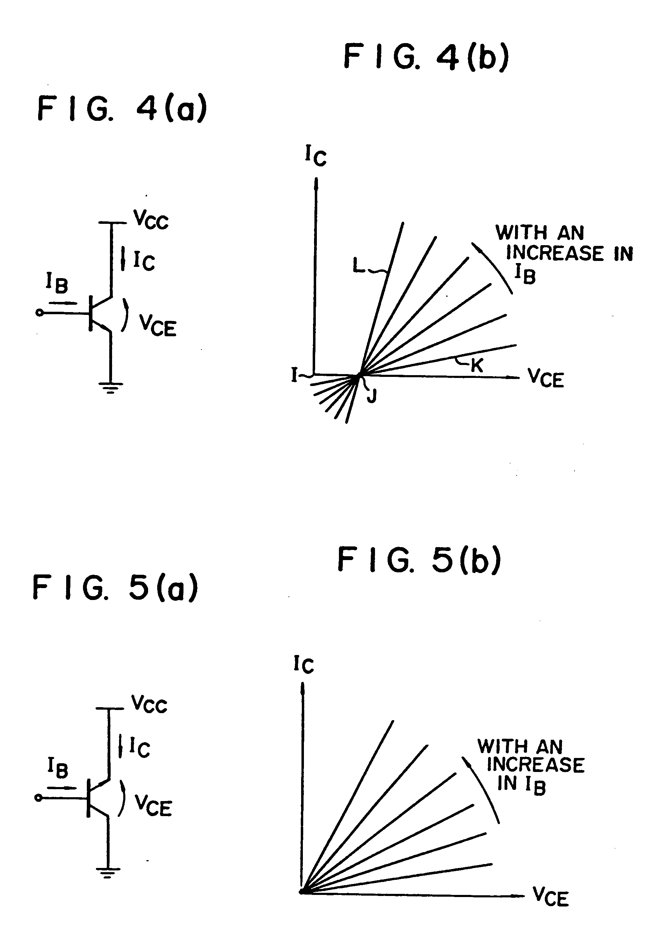

In this state, the switch SW is at a contact Ton. The output signal Vd of the ALC detector circuit 45 is applied to the base of the second transistor Q2. The second transistor Q2 is turned on to feed a current $I_{B1}$ based on the value of the signal Vd at the base of the first transistor Q1. Accordingly, the base current $I_{B1}$ of the transistor Q1 increases and decreases with the corresponding changes of the signal Vd. In the common emitter connection of a transistor, as shown in Fig. 4(a), when the base current $I_{B1}$ increases, the $I_C$ - $V_{CE}$ characteristic curve rotates in the direction from a curve K to a curve L, as shown in Fig. 4(b). On the other hand, when the base current $I_B$ decreases, the curve rotates in the reverse direction, i.e. from the curve L to the curve K. In other words, when the value of the signal Vd increases, the AC impedance between the collector and emitter of the first transistor Q1 decreases. Conversely, when the signal Vd decreases, the same AC impedance increases. The value of the AC signal S at point D is equal to the value obtained when the AC signal S is voltage-divided by the resistor R2 and the AC impedance of the first transistor Q1. Accordingly, the value of the AC signal S at point D increases with the increase of the AC impedance of the collector-emitter path of the first transistor Q1, and decreases with the decrease of the same. The increase of the amplitude of the signal S at point D causes the amplitude of the signal So from the amplifier 43 and the signal Vd from the ALC detector circuit 45 to increase. The result is that the base current of the first transistor Q1 increases, and the AC impedance of the first transistor Q1 decreases to make the value of the input signal S at point D smaller. With the decrease of the amplitude of the signal S, the signal So from the amplifier 43 and the signal Vd decreases. The base current of the first transistor Q1 decreases, and the AC impedance of the first transistor Q1 increases. The value of the input signal S at point D becomes larger. In this way, the amplitude of the signal So is constantly controlled against any change of the input signal S.

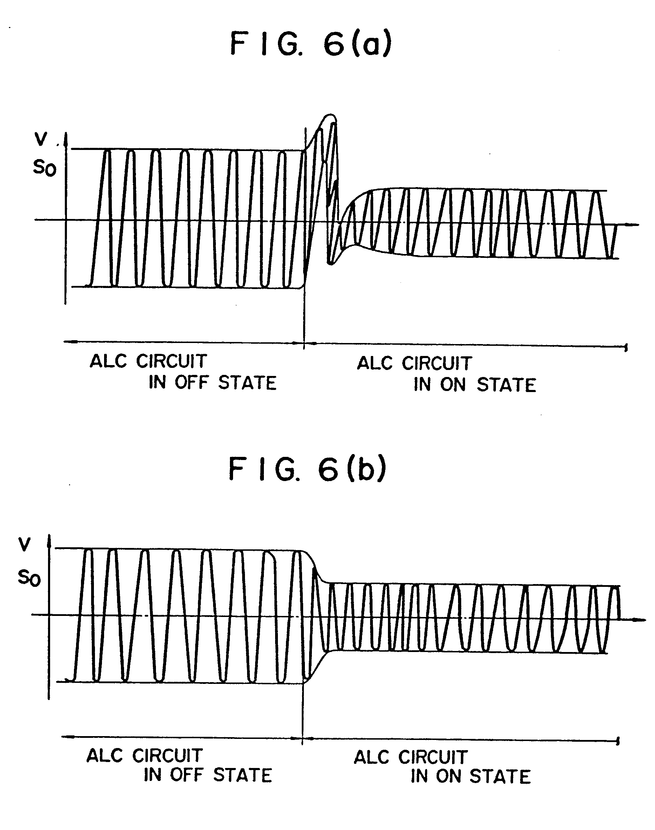

As already described, when the ALC circuit is in OFF state, the DC potential at point D is 1mV. On the other hand when it is in the ON state, the first transistor Q1 is operative to exhibit the characteristic as shown in Fig. 4(b). In this example, the transistor Q1 is operated at the DC collector current $I_C$ = 0 and the saturation voltage $V_{CE(sat)}$ is about 10mV at point J in Fig. 4(b). Therefore, a voltage of 10mV appears at the point D. When the ALC circuit is changed from OFF state to ON state, a voltage of about 10mV stepwise appears at the point D. If the amplification factor of the amplifier 43 is 300 (about 50dB), the amplifier 43 transiently produces the voltage 3V (10mV $\times$ 300 = 3V). The waveform of the output signal So output from the amplifier 43 is as shown in Fig. 6(a). As shown, the signal So abruptly rises immediately after the ALC circuit is turned on. This causes a transient sound to appear in addition to the desired sound when the magnetic tape having the signal So recorded therein is subjected to playback processing. This transient sound also is produced in the reverse state, viz. when the ALC circuit is changed from ON state to OFF, since the signal So abruptly changes in such a transient period.

To solve this problem, the first transistor Q1 may be connected in a common collector fashion, as shown in Fig. 5(a). In this transistor connection the saturation voltage $V_{CE(sat)}$ at $I_C$ = 0 is small as shown in Fig. 5(b). Therefore, the transient sound can be reduced. However, the linearity of the $I_C$ - $V_{CE}$ characteristic is poor, resulting in a great distortion of the signal So.

IBM Technical Disclosure Bulletin vol. 14 No. 1, June 1971 discloses a base ring transistor having features in common with the transistor of Figs. 1 and 2. Furthermore, an emitter ohmic contact region of the disclosed transistor extends into both an epitaxial layer formed on the substrate and the base region. However, no reason is given for extending the ohmic contact region into the base region. Furthermore, the document contains no discussion of how to reduce the saturation voltage at zero collector current, and no suggestion of applying the transistor to an ALC circuit.

An object of the present invention is to provide an automatic control circuit having a variable resistor element which has a small saturation voltage when the collector current $I_C$ is zero as well as good linearity of the $I_C$-$V_{CE}$ characteristic.

According to the invention, there is provided an automatic control circuit comprising:

a signal source for outputting a signal to be amplified;

a first bipolar transistor, one end of whose current path is arranged to receive the signal output from said signal source and the other end of whose current path is connected to circuit ground, said first transistor having a base terminal for receiving a control signal;

a second bipolar transistor, connected to the first transistor as an emitter follower stage;

an amplifier for amplifying a signal appearing at the output of said emitter follower stage and supplying it as an output signal of said automatic control circuit;

a switch for setting ON/OFF modes of said automatic control circuit; and

a detector circuit for receiving the signal output from said amplifier means, supplying to the base of said first transistor a first signal corresponding to the level of the signal output from said amplifier means, when said switch sets said automatic circuit in the ON mode, and for supplying to the base of said first transistor a second signal having a reference level, when said switch sets said automatic control circuit in the OFF mode;

said first bipolar transistor being a semiconductor device including:

a semiconductor substrate of a first conductivity type;

a first region of a second conductivity type, formed on said semiconductor substrate;

a base region of the first conductivity type, formed in said first region;

a second region of the second conductivity type, formed in said base region;

a buried layer of the second conductivity type, whose impurity concentration is higher than that of said first region a portion of said first region being interposed between said base region and said buried layer; and

a third region of the second conductivity type which extends into said first region, characterised in that said third region extends into said base region.

With such an arrangement, the first transistor provides a small saturation voltage when the device is operating and the collector current $I_C$ is zero. The semiconductor device can forwardly be used while being free from damaging the linearity of an AC impedance between the collector and emitter thereof. Transient sound generated at the ON and OFF transient periods of the switch can thus be removed, ensuring accurate control with little distortion.

This invention can be more fully understood from the following detailed description when taken in conjunction with the accompanying drawings, in which:

Fig. 1 shows a plan view of a structure of a prior art transistor;

Fig. 2 shows a cross-sectional view taken on line II - II in Fig. 1;

Fig. 3 is a circuit diagram of a general ALC circuit;

Fig. 4(a) is a schematic illustration of a transistor when it is connected in a common emitter fashion;

Fig. 4(b) is a graph illustrating an $I_C$ - $V_{CE}$ characteristic of the transistor shown in Fig. 4(a);

Fig. 5(a) is a schematic illustration of a transistor when it is connected in common collector fashion;

Fig. 5(b) is a graph illustrating the $I_C$ - $V_{CE}$ characteristic of the transistor shown in Fig. 5(b);

Fig. 6(a) illustrates a waveform of an output signal from an amplifier in an ALC circuit which uses the prior art transistor as a variable resistor element;

Fig. 6(b) illustrates a waveform of an output signal of an amplifier in an ALC circuit which uses a transistor according to the present invention as a variable resistor element;

Fig. 7 is a plan view illustrating a structure of a semiconductor device according to the present invention; and

Fig. 8 is a cross-sectional view taken on line VIII - VIII in Fig. 7.

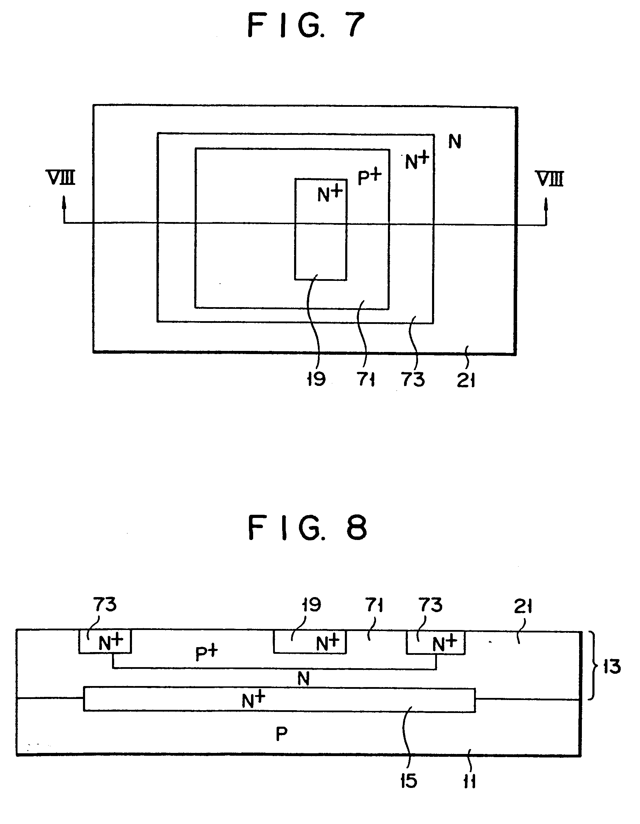

One embodiment of the present invention may be described as follows, with reference to Figs. 7 and 8. In those figures, like reference symbols are used for designating like or equivalent portions for simplicity. As shown, an N type high concentration layer 73 is formed in the semiconductor layer 13. And the high concentration layer 73 extends into a $P^+$ layer 71 as a base, extends into an N type layer 21 as a collector, and surrounds the $P^+$ layer 71. A transistor with such a structure is assembled as the first transistor Q1 in the ALC circuit shown in Fig. 3. The AC impedance between the collector 21 and the emitter 19 of the transistor Q1 is controlled by a controlling circuit made up of the second transistor Q2 and the resistor R1 as shown in Fig. 3. The control circuit controls the base current $I_{B1}$ as mentioned above.

Since the base 71 and the high concentration layer 73 of the collector 21 partially overlap each other, the emitter concentration of the NPN transistor in the inverse mode is increased, that is, the emitter injection efficiency in the inverse mode is improved. Therefore, the inverse current amplification factor of the transistor is large and the saturation voltage drops. The structural feature that the N type high concentration layer 73 surrounds the $P^+$ layer 71, satisfactorily improves the emitter injection efficiency of the NPN transistor in the inverse mode.

The reason why the saturation voltage drops will mathematically be described referring to equations (1) - (5). Generally, the saturation voltage of the bipolar type transistor is mathematically described as:

$$V_{CE(sat)} = -\frac{kT}{q} \ln \alpha i \; \frac{1 - I_C/\beta I_B}{1 + (I_C/I_B)(1 - \alpha i)} + I_C V_{SC} \qquad \ldots \ldots (1)$$

where $V_{CE(sat)}$ is the saturation voltage, k is the Boltzmann's constant ($1.38062 \times 10^{-23}$ J/° K), T is the absolute temperature (K), q is the charge of an electron ($1.60219 \times 10^{-19}$ C[b]), $\alpha i$ is the inverse base common current amplification factor (inverse $\alpha$), $\beta$ is the forward emitter common current amplification factor, $I_C$ is the collector current (DC component), $I_B$ is the base current (DC component), and $V_{SC}$ is the value of the collector series resistor. In Fig. 3, the first transistor Q1 is used under the condition $I_C$ = 0mA. The amplification factor $\alpha i$ is given as:

$$\alpha i = \frac{\beta i}{\beta i + 1} \qquad \ldots \ldots (2)$$

where $\beta i$ is the inverse emitter common current amplification factor (inverse $\beta$). Therefore, we can rewrite the formula (1) into the following equation:

$$V_{CE(sat.)} = - \frac{kT}{q} \ell n \alpha i = \frac{kT}{q} \ell n \frac{\beta i+1}{\beta i}$$

$$\doteqdot 26 \ [mV] \times \ell n \frac{\beta i+1}{\beta i}$$

$$\cdots\cdots (3)$$

In the prior art transistor shown in Figs. 1 and 2, the emitter concentration of the transistor in the inverse mode is low and the emitter injection efficiency is poor. The inverse common emitter current amplification factor $\beta i$ is approximately 2. Substituting this value into the equation (2), we have:

$$V_{CE(sat)} \doteqdot 26 \times \ell n \frac{2+1}{2} \doteqdot 10.5 \ [mV] \qquad \cdots\cdots (4)$$

On the other hand, in the transistor according to the present invention as shown in Figs. 7 and 8, the N type high concentration layer 73 partially extends into the base region 71. Therefore, the emitter concentration of the transistor in the inverse mode is high, its emitter injection efficiency is improved, and the inverse current amplification factor $\beta i$ is about 20. Substituting this value into the equation (2), we have:

$$V_{CE(sat)} \doteqdot 26 \times \ell n \frac{20+1}{20} \doteqdot 1.2 \ [mV] \qquad \cdots\cdots (5)$$

As seen from the equations (4) and (5), the saturation voltage of the transistor according to the present invention is considerably improved. Therefore, if this transistor is used in the ALC circuit of Fig. 3, no transient voltage is produced at the ON and OFF transient periods of the switch. This fact is diagramatically described in Fig. 6(b) illustrating a waveform of the output signal So of the amplifier 43. As illustrated, the waveform of the signal So smoothly changes at the transient period. Therefore, the transient sound problem of the prior art is successfully solved. Further, there is no need for the reverse connection of the transistor Q1 as shown in Fig. 5(a). This eliminates the linearity problem of the AC impedance between the collector and emitter of the first transistor Q1, ensuring an accurate control of level and gain.

In the above embodiment, the region 21 is used as the collector, the region 71 is used as the base, and the region 19 is used as the emitter. However, the present invention is not limited to this. The region 21 may be used as the emitter, the region 71 as the base, and the region 19 as the collector.

The base current feeding circuit made up of the second transistor Q2 and the resistor R1 may be substituted by any other circuit if it can feed the base current which changes the current according to the voltage Vd from the ALC detector circuit 45.

The semiconductor device according to the present invention is applicable not only for the ALC circuit, but also for any other circuit using variable resistor elements such as automatic gain control circuits (AGC circuit) and automatic volume control circuit (AVC circuit). The AGC circuit and AVC circuit have a similar structure with the ALC circuit. So the transistor of the present invention may be assembled into those circuits as variable resistor. And the transistor of the present invention may be assembled into any kind of control circuit having a variable resistor.

## Claims

1. An automatic control circuit comprising:
   a signal source (41) for outputting a signal to be amplified;
   a first bipolar transistor (Q1), one end of whose current path is arranged to receive the signal output from said signal source (41) and the other end of whose current path is connected to circuit ground, said first transistor (Q1) having a base terminal for receiving a control signal;
   a second bipolar transistor (Q3), connected to the first bipolar transistor (Q1) as an emitter follower stage;

5

an amplifier (43) for amplifying a signal appearing at the output of said emitter follower stage and supplying it as an output signal of said automatic control circuit;

a switch (SW) for setting ON/OFF modes of said automatic control circuit; and

a detector circuit (45,Q2 and R1) for receiving the signal output from said amplifier (43), supplying to the base of said first transistor (Q1) a first signal corresponding to the level of the signal output from said amplifier (43), when said switch (SW) sets said automatic control circuit in the ON mode, and for supplying to the base of said first transistor (Q1) a second signal having a reference level, when said switch (SW) sets said automatic control circuit in the OFF mode;

said first bipolar transistor (Q1) including:

a semiconductor substrate (11) of a first conductivity type;

a first region (21) of a second conductivity type, formed on said semiconductor substrate (11);

a base region (71) of the first conductivity type, formed in said first region (21);

a second region (19) of the second conductivity type, formed in said base region (71);

a buried layer (15) of the second conductivity type, whose impurity concentration is higher than that of said first region (21), a portion of said first region (21) being interposed between said base region (71) and said buried layer (15); and

a third region (73) of the second conductivity type which extends into said first region (21), characterized in that said third region (73) extends into said base region (71).

2. An automatic control circuit according to claim 1, characterized in that said third region (73) surrounds said base region (71).

3. An automatic control circuit according to claim 1 or 2, characterized in that said second conductivity type is N-type and said third region has a higher impurity concentration than said first region (21).

4. An automatic control circuit according to any preceding claim wherein the circuit is an automatic level control circuit.

5. An automatic control circuit according to any of claims 1 to 3 wherein the circuit is an automatic gain control circuit.

6. An automatic control circuit according to any of claims 1 to 3 wherein the circuit is an automatic volume control circuit.

**Patentansprüche**

1. Automatische Steuerschaltung, umfassend:

eine Signalquelle (41) zum Ausgeben eines zu verstärkenden Signals;

einen ersten Bipolartransistor (Q1), bei dem ein Ende des Strompfades zum Empfangen des von der Signalquelle (41) ausgegebenen Signals geschaltet ist, während das andere Ende des Strompfades mit Masse verbunden ist, wobei der erste Transistor (Q1) einen Basisanschluß zum Empfangen eines Steuersignals besitzt;

einen zweiten Bipolartransistor (Q3), der als Emitterfolgestufe an den ersten Bipolartransistor (Q1) angeschlossen ist;

einen Verstärker (43) zum Verstärken eines am Ausgang der Emitterfolgerstufe auftretenden Signals und zum Liefern des Signals als Ausgangssignal der automatischen Steuerschaltung;

einen Schalter (SW) zum Setzen der EIN/AUS-Moden der automatischen Steuerschaltung; und

eine Detektorschaltung (45, Q2 und R1) zum Empfangen des vom Verstärker (43) ausgegebenen Signals; zum Liefern eines ersten Signals entsprechend dem Pegel des vom Verstärker (43) ausgegebenen Signals an die Basis des ersten Transistors (Q1), wenn der Schalter (SW) die automatische Steuerschaltung in den EIN-Modus setzt; und zum Liefern eines zweiten Signals mit einem Bezugspegel an den ersten Transistor (Q1), wenn der Schalter (SW) die automatische Steuerschaltung in den AUS-Modus setzt;

wobei der erste Bipolartransistor (Q1) aufweist:

ein Halbleitersubstrat (11) eines ersten Leitungstyps;

einen ersten Bereich (21) eines zweiten Leitungstyps, der auf dem Halbleitersubstrat (11) gebildet ist;

einen Basisbereich (71) des ersten Leitungstyps, der auf dem ersten Bereich (21) gebildet ist;

einen zweiten Bereich (19) des zweiten Leitungstyps, der auf den Basisbereichen (71) gebildet ist;

eine vergrabene Schicht (15) des zweiten Leitungstyps, dessen Störstellenkonzentration größer als diejenige des ersten Bereiches (21) ist, wobei ein Abschnitt des ersten Bereiches (21) zwischen dem Basisbereich (71) und die vergrabene Schicht (15) eingefügt ist; und

einen dritten Bereich (73) des zweiten Leitungstyps, der sich in den ersten Bereich (21) erstreckt,

dadurch **gekennnzeichnet,**

daß sich der dritte Bereich (73) in den Basisbereich (71) erstreckt.

2.  Automatische Steuerschaltung nach Anspruch 1, dadurch gekennzeichnet, daß der dritte Bereich (73) den Basisbereich (71) umgibt.

3.  Automatische Steuerschaltung nach Anspruch 1 oder 2, dadurch gekennzeichnet, daß der zweite Leitungstyp ein N-Typ ist und der dritte Bereich eine höhere Störstellenkonzentration als der erste Bereich (21) besitzt.

4.  Automatische Steuerschaltung nach einem beliebigen vorhergehenden Anspruch, wobei die Schaltung eine automatische Pegelsteuerschaltung ist.

5.  Automatische Steuerschaltung nach einem beliebigen Anspruch 1 bis 3, wobei die Schaltung eine automatische Gewinnsteuerschaltung ist.

6.  Automatische Steuerschaltung nach einem beliebigen Anspruch 1 bis 3, wobei die Schaltung eine automatische Lautstärkesteuerschaltung ist.

**Revendications**

1.  Circuit de commande automatique comprenant :
    une source de signal (41) pour émettre en sortie un signal qui doit être amplifié ;
    un premier transistor bipolaire (Q1) dont une extrémité de la voie de courant est agencée pour recevoir la sortie de signal en provenance de ladite source de signal (41) et dont l'autre extrémité de la voie de courant est connectée à une masse du circuit, ledit premier transistor (Q1) comportant une borne de base pour recevoir un signal de commande ;
    un second transistor bipolaire (Q3) connecté au premier transistor bipolaire (Q1) en tant qu'étage à émetteur suiveur ;
    un amplificateur (43) pour amplifier un signal qui apparaît à la sortie dudit étage suiveur à émetteur suiveur et pour l'appliquer en tant que signal de sortie dudit circuit de commande automatique ;
    un commutateur (SW) pour établir des modes MARCHE/ARRET dudit circuit de commande automatique ; et
    un circuit détecteur (45, Q2 et R1) pour recevoir la sortie de signal en provenance dudit amplificateur (43), pour appliquer à la base dudit premier transistor (Q1) un premier signal correspondant au niveau de la sortie de signal en provenance dudit amplificateur (43) lorsque ledit commutateur (SW) établit ledit circuit de commande automatique dans le mode MARCHE et pour appliquer à la base dudit premier transistor (Q1) un second signal présentant un niveau de référence lorsque ledit commutateur (SW) établit ledit circuit de commande automatique dans le mode ARRET ;

7

EP 0 121 198 B1

ledit premier transistor bipolaire (Q1) incluant :

un substrat semiconducteur (11) d'un premier type de conductivité ;

une première région (21) d'un second type de conductivité formée sur ledit substrat semiconducteur (11) ;

une région de base (71) du premier type de conductivité formée dans ladite première région (21) ;

une seconde région (19) du second type de conductivité formée dans ladite région de base (71) ;

une couche enterrée (15) du second type de conductivité dont la concentration en impuretés est supérieure à celle de ladite première région (21), une partie de ladite première région (21) étant interposée entre ladite région de base (71) et ladite couche enterrée (15) ; et

une troisième région (73) du second type de conductivité qui s'étend à l'intérieur de ladite première région (21), caractérisé en ce que ladite troisième région (73) s'étend à l'intérieur de ladite région de base (71).

2. Circuit de commande automatique selon la revendication 1, caractérisé en ce que ladite troisième région (73) entoure ladite région de base (71).

3. Circuit de commande automatique selon la revendication 1 ou 2, caractérisé en ce que ledit second type de conductivité est le type N et en ce que ladite troisième région présente une concentration en impuretés supérieure à celle de ladite première région (21).

4. Circuit de commande automatique selon l'une quelconque des revendications précédentes, dans lequel le circuit est un circuit de commande de niveau automatique.

5. Circuit de commande automatique selon l'une quelconque des revendications 1 à 3, dans lequel le circuit est un circuit de commande de gain automatique.

6. Circuit de commande automatique selon l'une quelconque des revendications 1 à 3, dans lequel le circuit est un circuit de commande de volume automatique.

8

# FIG. 1

21    17    19        23    21

# FIG. 2

# FIG. 3

# F I G. 4(b)

# F I G. 4(a)

# F I G. 5(b)

# F I G. 5(a)

# F I G. 6(a)

ALC CIRCUIT
IN OFF STATE

ALC CIRCUIT
IN ON STATE

# F I G. 6(b)

ALC CIRCUIT
IN OFF STATE

ALC CIRCUIT
IN ON STATE

# FIG. 7

N

N+

P+

N+

VIII          VIII

19   71   73   21

# FIG. 8

73          19   71   73          21

N+      P+      N+      N+

13

N

N+

P

15   11